# FASCICULE DE BREVET EUROPEEN

(11) **EP 1 041 863 B1**
(45) Date de publication et mention de la délivrance du brevet: **20.10.2004**
(21) Numéro de dépôt: 00400878.5
(22) Date de dépôt: 30.03.2000
(51) Int. Cl.: H05H 1/24, H05H 1/48

(54) **Cellule à plasma**
Plasmazelle
Plasma cell

(30) Priorité: 01.04.1999 FR 9904083
(43) Date de publication de la demande: 04.10.2000
(73) Titulaire: COMMISSARIAT A L'ENERGIE ATOMIQUE, 75015 Paris Cédex 15 (FR)
(72) Inventeur: Picard, Emmanuel, 38410 Saint Martin d'Uriage (FR); Magnea, Noel, 38430 Moirans (FR)
(74) Mandataire: Poulin, Gérard

(56) Documents cités:
- FR-A- 2 355 375
- JP-A- 1 060 926
- US-A- 5 427 747

## Description

### Domaine technique

La présente invention concerne une cellule à plasma.

### Etat de la technique antérieure

Différentes cellules à plasma existent à l'heure actuelle sur le marché. Ce sont :
- les cellules à filaments chauds, qui sont des cellules de conception simple, permettant uniquement de fabriquer de l'hydrogène monoatomique ; l'hydrogène diatomique se dissociant grâce à l'énergie fournie par un filament porté à haute température ;
- les cellules à plasma radiofréquence et à résonance cycloélectronique, qui sont des cellules de fabrication compliquée et très onéreuses, qui produisent des espèces ionisées qui peuvent endommager les surfaces ;
- les cellules à plasma à décharge continue.

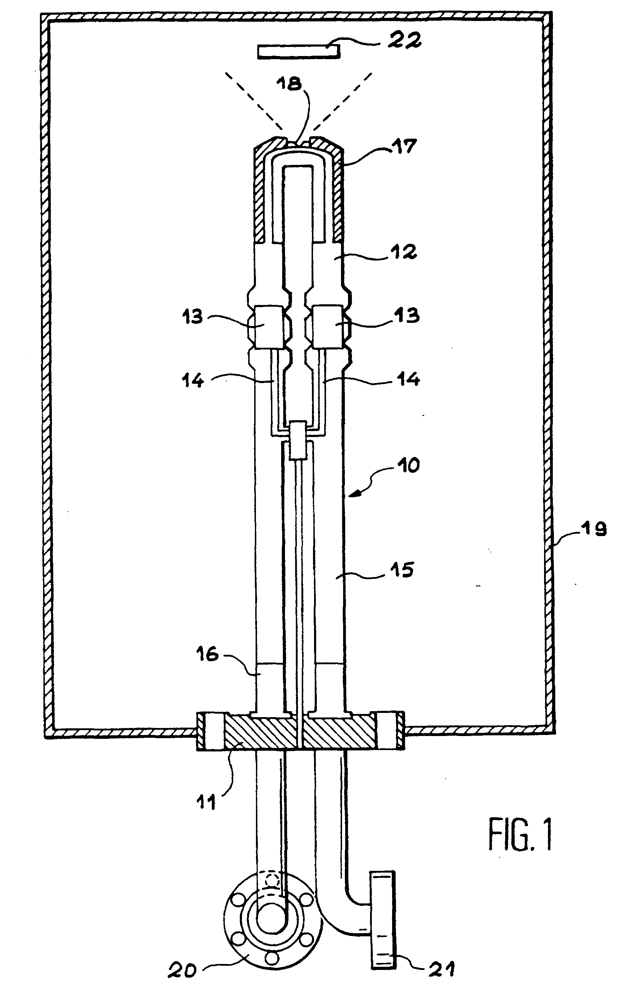

Une cellule de ce dernier type, disponible dans le commerce et décrite par exemple dans le document référencé [1] en fin de description, est illustrée sur la figure 1. Elle est formée par un tube à décharge 10 recourbé sur lui-même et monté sur une bride ultravide 11 de type CF 35 permettant de fixer celle-ci dans une chambre sous vide 19, dans laquelle la pression est de l'ordre de 10⁻⁵ à 10⁻⁶ mbar. Sur cette figure sont illustrés un tube en quartz 12, des électrodes en platine 13 et leurs connexions électriques 14, un tube en verre thermique 15 et un tube en acier inoxydable 16. La partie supérieure de la cellule est munie d'un couvercle de protection 17 et d'un orifice conique 18 pour la sortie du plasma. Une première bride 20 de type CF 16 permet d'effectuer l'introduction d'oxygène et une seconde bride 21 de même type permet une liaison à un système de pompage.

Un plasma est créé entre les deux électrodes 13 en appliquant une tension continue de quelques milliers de volts, le courant ainsi généré pouvant varier de 20 mA à 40 mA. L'ionisation du gaz produit des espèces monoatomiques qui sortent par l'orifice 18 et qui vont réagir avec l'échantillon 22 situé en face de celui-ci.

L'inconvénient majeur de telles cellules réside dans la présence de soudures verre-métal et dans leur fragilité, ce qui les rend indémontables. Ces cellules ne peuvent pas être nettoyées (il y a en effet un dépôt sur les parois de la cellule) et ont donc une durée de vie assez courte. De plus, les électrodes n'étant pas interchangeables, ces cellules sont donc « monogaz » et doivent être remplacées à chaque nouvelle application, la création d'une espèce atomique nécessitant en effet l'association d'un gaz et d'une électrode spécifique : Pt pour O₂ - Inox pour H₂ - Mo pour N₂...

L'invention a pour objectif de pallier les inconvénients de ces cellules de l'art connu en proposant une cellule à plasma de faible coût, de maintenance aisée, avec des électrodes facilement interchangeables, pouvant être ainsi utilisée avec différents types de gaz.

### Exposé de l'invention

La présente invention concerne une cellule à plasma, apte à être fixée dans une chambre sous vide au moyen d'une première bride, comprenant une enveloppe extérieure en matériau isolant électrique dans laquelle est disposé un gaz sous pression, munie en sa partie supérieure d'un orifice d'éjection, et des électrodes, au moins une anode et une cathode, disposées dans ladite enveloppe et montées sur une seconde bride, aux bornes desquelles une tension peut être appliquée de manière à réaliser l'ionisation du gaz produisant les espèces monoatomiques devant sortir par l'orifice, caractérisée en ce qu'elle comprend des électrodes démontables et montées sur une seconde bride amovible, des moyens de séparation électriquement isolés disposés entre la cathode et la (ou les) anode(s), et un orifice d'entrée de gaz.

Dans une réalisation avantageuse, l'enveloppe a la forme d'une cloche en verre. Les moyens de séparation sont formés d'un tube en quartz disposé autour de la cathode. Les électrodes, qui comprennent plusieurs anodes, sont disposées de manière à permettre la sélection électrique d'une anode. L'orifice d'entrée de gaz est situé dans la partie basse de l'enveloppe située entre les deux brides.

Avantageusement une telle cellule permet de créer des espèces monoatomiques de différents gaz. Sa durée de vie n'est pas limitée puisque on peut la nettoyer et changer les électrodes. De plus sa fabrication se retrouve très simplifiée.

Elle permet de fabriquer des espèces atomiques de gaz à partir de sources moléculaires telles que hydrogène, oxygène, azote, dans une chambre sous vide. Les espèces monoatomiques ainsi créées de part leur grande réactivité sont utilisées soit pour doper, soit pour changer l'état des surfaces (nettoyage, désoxydation, oxydation).

### Brève description des dessins

La figure 1 illustre schématiquement une cellule à plasma à décharge continue de l'art connu disposée dans une chambre sous vide.

La figure 2 illustre schématiquement une cellule à plasma selon l'invention disposée dans une chambre sous vide.

### Exposé détaillé de modes de réalisation

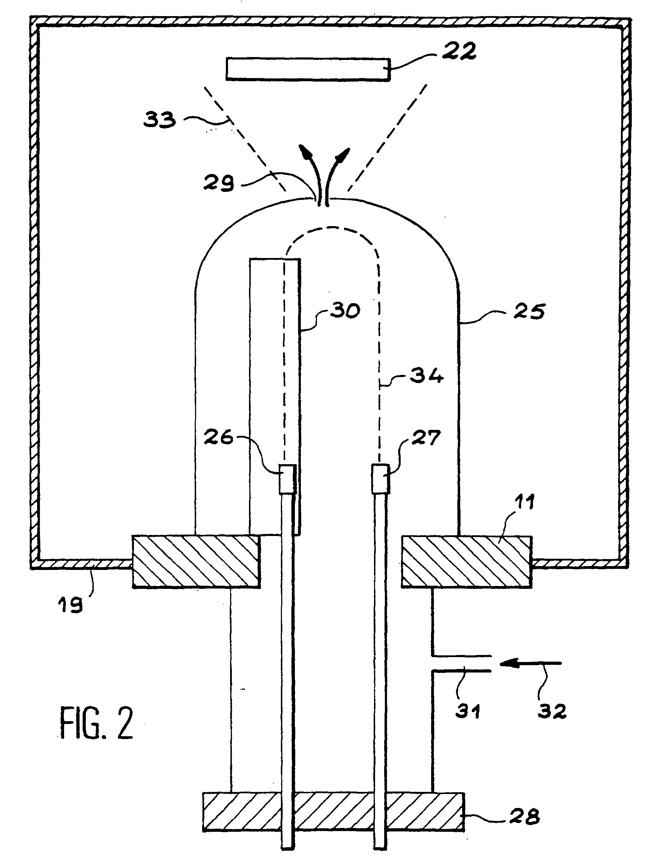

La cellule à plasma de l'invention est illustrée sur la figure 2.

Elle comprend une enveloppe 25 par exemple en verre, en quartz, en alumine ou en pyrex de forme simple, telle qu'une cloche par exemple, comportant des électrodes, c'est-à-dire au moins une cathode 26 et une anode 27. Elle est munie en sa partie supérieure d'un orifice d'éjection 29, d'une première bride 11, de type CF 35, comme dans la cellule illustrée sur la figure 1, permettant une fixation dans la chambre sous vide 19. La pression dans la cellule P' est supérieure à la pression P dans ladite chambre qui est de l'ordre de 10⁻⁵ mbar.

Les électrodes démontables 26 et 27, montées sur une seconde bride amovible 28, de type CF 19, n'ont aucune liaison avec la paroi en verre 25. Un orifice 31 d'entrée de gaz 32 est disposé dans la partie basse de l'enveloppe située entre les deux brides 11 et 28.

Les électrodes peuvent être alimentées par une tension continue, alternative ou pulsée afin de créer, selon l'application envisagée, une décharge d'espèces atomiques continue ou discontinue dans le temps.

Pour éviter qu'un régime de plasma ne s'installe « en direct » entre les deux électrodes 26 et 27 et ne crée d'espèces atomiques, la cellule comprend de plus une séparation physique électriquement isolée 30 entre les électrodes, cette séparation pouvant être réalisée par exemple par un tube en quartz 30 entourant la cathode 26, comme illustré sur la figure 2.

Cette séparation physique 30 doit vérifier deux critères. Premièrement, elle doit être en matériau isolant électrique comme par exemple en verre, en quartz, en alumine ou en pyrex. Deuxièmement, elle doit séparer matériellement l'anode de la cathode. Sa forme n'est donc pas essentielle : elle peut par exemple être de forme cylindrique comme représenté sur la figure 2,ou de toute autre forme fermée entourant la cathode, ou de forme plane.

Cette séparation physique 30 a pour objet de jouer les rôles suivants :
- Instaurer un régime particulier qui crée des espèces atomiques.
- Faire passer le « faisceau » 34, qui relie l'anode 27 à la cathode 26, à proximité de l'orifice d'éjection 29. Les particules soumises à une pression P' supérieure à la pression extérieure P sont alors éjectées par cet orifice 29, selon un cône d'émission 33.

Le positionnement de la séparation 30 permet de créer des espèces actives au niveau de l'orifice 29. En l'absence de cette séparation 30 un autre régime de plasma stable s'établirait entre l'anode. 27 et la cathode 26 sans production d'espèces atomiques au niveau de l'orifice 29.

Des études d'analyses chimiques ont montré que la cellule de l'invention permet par création d'atomes d'hydrogène d'éliminer totalement la couche d'oxyde sur plusieurs matériaux (CdTe, GaAs...) par création d'espèces volatiles (H₂O-OH). De plus elle permet aussi d'éliminer un certain nombre de contaminants de surface(carbone, chlore, brome) par création d'autres espèces volatiles (CH₄-HCl-HBr).

Une telle cellule, dont la mise en oeuvre est très simple, permet
- Un démontage facile. Il suffit de démonter la bride porte-électrodes 28 pour accéder à l'intérieur de l'enveloppe en verre 25, d'où un nettoyage aisé et un remplacement possible des électrodes.
- La possibilité d'avoir une seule cathode 26 et plusieurs anodes 27, disposées de manière à pouvoir sélectionner électriquement l'anode spécifique à l'application envisagée sans que cela nécessite un changement de cellule.

### REFERENCE

- [1]: Thèse de D. Pagnon du 24 septembre 1992 intitulée « Etude de la dissociation de O₂ dans les décharges d'oxygène - Application à la réalisation de sources d'atomes » (chapitre 4 - Etude d'une source d'atomes O - pages 71 à 80)

## Revendications

1. Cellule à plasma, apte à être fixée dans une chambre à vide (19) au moyen d'une première bride (11), comprenant une enveloppe extérieure en matériau isolant électrique (25) dans laquelle est disposé un gaz sous pression (P'), munie en sa partie supérieure d'un orifice d'éjection (29), et des électrodes, au moins une anode (27) et une cathode (26), disposées dans ladite enveloppe et montées sur une seconde bride (28), aux bornes desquelles une tension peut être appliquée de manière à réaliser l'ionisation du gaz produisant les espèces monoatomiques devant sortir par l'orifice (29), **caractérisée en ce qu'**elle comprend des électrodes (26, 27) démontables et montées sur une seconde bride (28) amovible, des moyens de séparation (30) électriquement isolés, disposés entre la cathode (26) et la (ou les) anode(s) (27), et un orifice (31) d'entrée de gaz.

2. Cellule selon la revendication 1, dans laquelle l'enveloppe (25) a la forme d'une cloche.

3. Cellule selon la revendication 2, dans laquelle l'enveloppe (25) en forme de cloche est en verre.

4. Cellule selon la revendication 1, dans laquelle les moyens de séparation sont formés d'un tube en quartz (30) disposé autour de la cathode (26).

5. Cellule selon la revendication 1, dans laquelle les électrodes, qui comprennent plusieurs anodes, sont disposées de manière à permettre la sélection électrique d'une anode.

6. Cellule selon la revendication 1, dans laquelle l'orifice (31) d'entrée de gaz est situé dans la partie base de l'enveloppe située entre les deux brides (11, 28).

## Claims

1. Plasma cell, able to be fixed in a vacuum chamber (19) by means of a first flange (11), comprising an outer envelope in electric insulating material (25) in which a gas under pressure (P') is added and provided in its upper part with a discharge opening (29), and electrodes, at least one anode (27) and one cathode (26), arranged in said envelope and mounted on a second flange (28), to whose terminals a voltage may be applied, such as to cause ionization of the gas producing the monoatomic species which are to be discharged through opening (29), **characterized in that** it comprises electrodes (26, 27) which can be dismounted and are assembled on a second removable flange (28), electrically insulated separation means (30) arranged between cathode (26) and anode(s) (27), and a gas inlet opening (31).

2. Cell according to claim 1, in which envelope (25) is bell-shaped.

3. Cell according to claim 2, in which the bell-shaped envelope (25) is in glass.

4. Cell according to claim 1, in which the separation means are formed of a quartz tube (30) arranged around the cathode (26).

5. Cell according to claim 1, in which the electrodes, which comprise several anodes, are arranged such as to allow electric selection of an anode.

6. Cell according to claim 1, in which the gas inlet opening (31) is located in the lower part of the envelope situated between the two flanges (11, 28).

## Patentansprüche

1. Plasmazelle, geeignet zur Befestigung in einer Vakuumkammer (19) mittels eines ersten Flansches (11), eine Außenhülle (25) aus elektrisch isolierendem Material, in der sich ein Gas unter einem Druck (P') befindet und die eine Austrittsöffnung (29) an ihrer Oberseite aufweist, und Elektroden umfassend, wenigstens eine Anode (27) und eine Katode (26), angeordnet in der genannten Hülle und auf einen zweiten Flansch (28) montiert, an deren Anschlüsse eine Spannung angelegt werden kann, um das Gas zu ionisieren, so dass es monoatomare Spezies erzeugt, die durch die Öffnung (29) austreten müssen,
**dadurch gekennzeichnet,**
**dass** sie demontierbare und auf einen lösbaren zweiten Flansch (28) montierte Elektroden (26, 27) und elektrisch isolierte Trenneinrichtungen (30) umfasst, angeordnet zwischen der Katode (26) und der (oder den) Anode(n) (27), sowie eine Gaseintrittsöffnung (31).

2. Zelle nach Anspruch 1, bei der die Hülle (25) die Form einer Glocke hat.

3. Zelle nach Anspruch 2, bei der die glockenförmige Hülle (25) aus Glas ist.

4. Zelle nach Anspruch 1, bei der die Trenneinrichtungen durch eine die Katode (26) umschließende Quarzröhre (30) gebildet werden.

5. Zelle nach Anspruch 1, bei der die Elektroden, die mehrere Anoden umfassen, so angeordnet sind, dass sie die elektrische Selektion einer Anode ermöglichen.

6. Zelle nach Anspruch 1, bei der die Gaseintrittsöffnung (31) sich in dem unteren Teil der Hülle befindet, zwischen den beiden Flanschen (11, 28).
